# FASCICULE DE BREVET EUROPEEN

(11) **EP 1 178 718 B1**
(45) Date de publication et mention de la délivrance du brevet: **23.08.2006**
(21) Numéro de dépôt: 01402071.3
(22) Date de dépôt: 31.07.2001
(51) Int. Cl.: H05K 13/02, H05K 13/04

(54) **Dispositif de prélèvement de composants**
Vorrichtung zur Entnahme von Komponenten
Device for extracting components

(30) Priorité: 04.08.2000 FR 0010321
(43) Date de publication de la demande: 06.02.2002
(73) Titulaire: United Monolithic Semiconductor S.A.S., 91400 Orsay (FR)
(72) Inventeur: Belloche, Thierry THALES Intell. Prop., 94117 Arcueil Cedex (FR); Harand, Bernard THALES Intell. Prop., 94117 Arcueil Cedex (FR); Sebire, Marc THALES Intell. Prop., 94117 Arcueil Cedex (FR)
(74) Mandataire: Dudouit, Isabelle

(56) Documents cités:
- EP-A- 0 565 781
- JP-A- 3 161 999
- US-A- 5 589 029

## Description

L'invention se rapporte à un dispositif de prélèvement de composants électroniques plats réalisés sur un substrat à base par exemple de silicium ou d'arséniure de gallium. Ces composants sont plus communément appelés « puces ». Ces composants, généralement de forme rectangulaire, ont une surface de l'ordre de quelques millimètres carrés, ils sont réalisés sur des galettes de substrat dont l'épaisseur est de l'ordre de quelques centaines de micromètres. Dans certains cas, l'épaisseur du substrat, notamment pour l'arséniure de gallium, peut être réduite jusqu'à 50 micromètres, ce qui rend les composants fragiles. Ces composants sont fabriqués en lots sur une galette de substrat et à l'issue de la réalisation d'une galette, celle-ci est collée sur un film plastique. La galette est ensuite découpée pour séparer les différents composants d'un lot. La découpe peut être réalisée au moyen d'une pointe en diamant marquant à la galette entre les composants du lot. La séparation des composants est ensuite obtenue en appliquant une onde de choc sur le dessus de la galette. A l'issue de la découpe, pour faciliter l'opération de prélèvement des composants, le film peut être étiré, ce qui augmente l'espace disponible entre chaque composant. On effectue l'opération d'étirement du film en le plaçant sur un anneau. La découpe peut également être réalisée par sciage au moyen d'une lame de scie dont l'épaisseur est, par exemple, de l'ordre de 30 µm. Une telle lame de scie laisse un espace d'environ 50 µm entre les composants et on peut se passer de l'opération d'étirement du film. Le film est placé sur un cadre métallique de forme quelconque. La dernière opération de fabrication des composants consiste à les prélever du film plastique pour les placer dans des boîtes de transport.

Il existe plusieurs procédés de prélèvement. Tout d'abord un procédé particulièrement adapté au prélèvement unitaire, par exemple pour effectuer des tests de mise au point du composant. Ce procédé consiste à prélever un composant sur le film étiré ou non à l'aide de pinces de type brucelles. Le faible espace disponible entre chaque composant ainsi que l'épaisseur réduite de chaque composant impose souvent de commencer le prélèvement par les composants situés sur les bords de la galette. Il est très difficile, voire impossible, d'accéder directement à un composant situé au centre de la galette pour le prélever sans avoir, auparavant, prélevé au moins un composant voisin.

Un autre procédé de prélèvement, adapté celui-ci au prélèvement automatisé, par exemple en fabrication de série, consiste à soulever le composant du film parallèlement au plan initial du film au moyen d'une ou plusieurs aiguilles traversant le film. Le composant est ainsi décollé du film et peut être déplacé vers une boîte de stockage au moyen d'une pipette pneumatique. Un tel procédé est par exemple connu de US-A-5 589 029 ou EP-A-0 565 781.

Dans ce procédé, il est possible de prélever n'importe quel composant, même situé au centre de la galette indépendamment de ses voisins. Par contre, ce procédé ne s'adapte pas à tous les formats de composants. Notamment les composants de faible épaisseur ont tendance à se briser lors du décollage du film.

L'invention a pour but de pallier les inconvénients des procédés présentés ci-dessus. Pour atteindre ce but, l'invention propose un dispositif adapté à tous les formats de composant, utilisable aussi bien pour effectuer des prélèvements unitaires que de série de façon automatisée.

A cet effet, l'invention a pour objet un dispositif de prélèvement d'un ou plusieurs composant(s) électronique(s) plat(s), disposés adjacents les uns par rapport aux autres, sur une première face d'un film, caractérisé en ce qu'il comporte des moyens pour soulever le composant du film à partir de la face opposée du film sur un des côtés du composant uniquement et assurer ainsi un décollage progressif du film à partir de ce côté jusqu'au côté opposé.

L'invention sera mieux comprise et d'autres avantages apparaîtront à la lecture de la description détaillée d'un mode de réalisation particulier illustré par le dessin joint dans lequel :
la figure 1 représente en coupe un dispositif conforme à l'invention ;

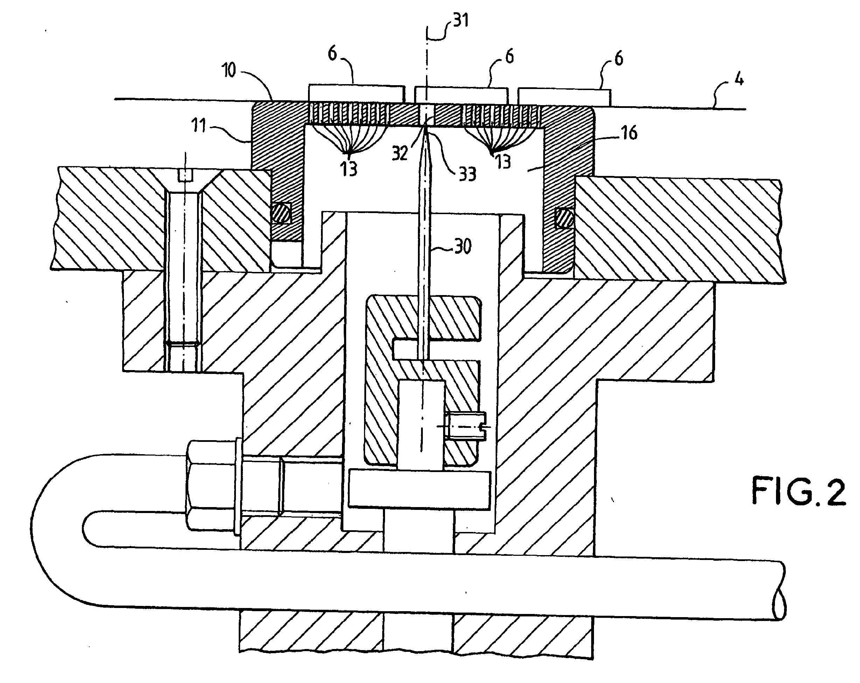

• la figure 2 représente un détail de ce dispositif où une aiguille destinée à soulever un composant est en position basse ;
• la figure 3 représente le même détail que celui représenté figure 2, où l'aiguille est en position haute.

Pour plus de simplicité, dans la suite de la description, les mêmes éléments portent les mêmes repères topologiques dans les différentes figures.

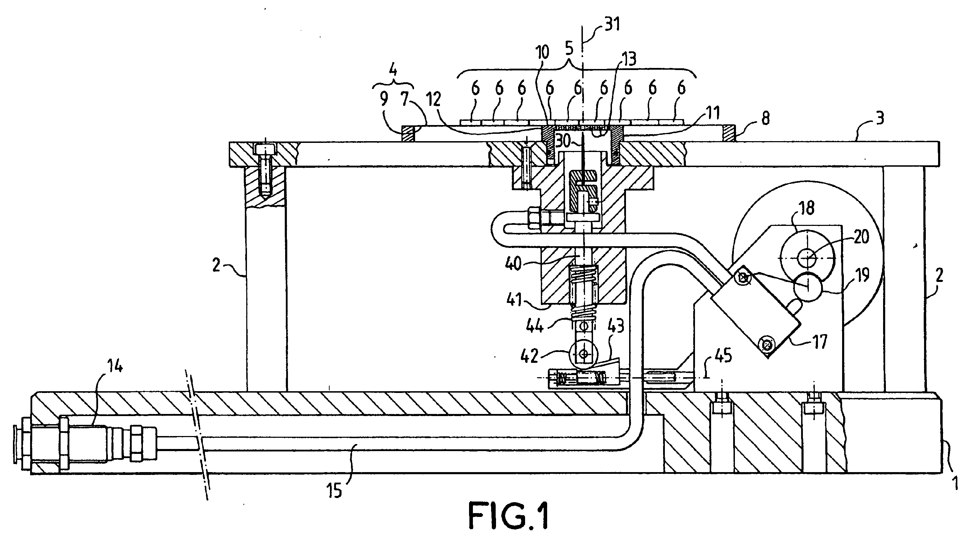

Les différents éléments du dispositif représenté figure 1 sont portés par un socle 1. Des montants 2, sensiblement verticaux et solidaires du socle 1, supportent une table 3 ayant la forme d'une plaque sensiblement horizontale. C'est sur cette table que l'on place un film plastique 4 sur lequel est collée une galette 5 de composants 6 plats, galette 5 de laquelle on cherche à prélever un ou plusieurs composants 6 pour, par exemple, les placer dans une boîte de transport. Les composants 6 sont disposés adjacents les uns par rapport aux autres sur une première face 7 du film 4. Sur les différentes figures, il s'agit de la face supérieure du film 4.

Le film 4 est par exemple solidaire d'un anneau 8 ou d'un cadre métallique maintenant le film 4 à une distance donnée de la table 3.

Le dispositif comporte des moyens pour maintenir une deuxième face 9 du film 4 en appui sur une surface plane 10 d'un support 11. Sur les différentes figures, la deuxième face 9 est la face inférieure du film 4. Le support 11 a par exemple la forme d'un cylindre fermé à l'une de ses extrémités par un fond 12 dont la face supérieure est la surface plane 10. La surface plane 10 est distante de la table 3 sensiblement de la distance donnée définie par l'anneau 8. Il est possible d'utiliser un anneau 8 ou un cadre métallique maintenant le film 4 à une distance de la table 3, distance inférieure (voire nulle) de celle existant entre la surface plane 10 du support 11 et la table 3. Dans ce cas, on peut utiliser un plateau placé entre la table 3 et l'anneau 8 ou le cadre métallique, le plateau entourant le support 11. Ce plateau compense la différence de hauteur entre le support et le cadre métallique ou l'anneau. L'intérieur du support 11 est soumis à une dépression par rapport à l'air ambiant et au moins un orifice 13 traverse le fond 12 et débouche sur la surface plane 10. Ainsi la dépression réalisée à l'intérieur du support 11 tend à aspirer le film 4 et donc à le maintenir en appui contre la surface plane 10 du support 11. Des moyens générant la dépression peuvent être extérieurs au dispositif. Un raccord pneumatique 14 raccorde ces moyens à une canalisation 15 débouchant dans une chambre 16 située à l'intérieur du support 11. Cette chambre communique à l'extérieur par le ou les orifices 13. Pour faciliter la manutention du film 4 monté sur son anneau 8, la canalisation 15 peut être interrompue par un distributeur 17 susceptible de raccorder la chambre 16 soit aux moyens générant la dépression, soit à l'échappement afin de libérer le film 4 de son appui contre la surface plane 10 du support 11. Le distributeur est par exemple commandé au moyen d'une came 18 pouvant déplacer un galet 19 dans sa rotation autour d'un axe 20. Le galet 19 déplace le tiroir du distributeur, tiroir non représenté sur les figures.

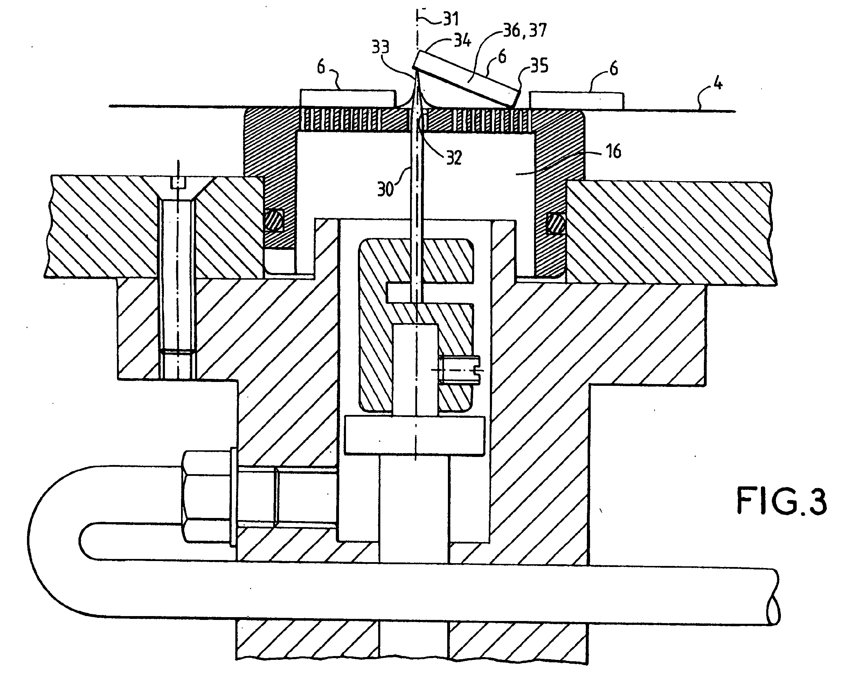

Le dispositif comporte, par ailleurs, des moyens pour soulever au moins un composant 6 du film 4 sur un de ses côtés. Ces moyens sont visibles sur les différentes figures. Ils comportent par exemple au moins une aiguille 30 pouvant se déplacer suivant son axe 31. L'axe 31 est sensiblement perpendiculaire à la surface plane 10 du support 11. Au repos, l'aiguille 30 est située complètement à l'intérieur de la chambre 16. Pour prélever un composant 6 situé sur le film 4, on déplace l'aiguille 30 en suivant l'axe 31 vers le haut. L'aiguille 30 traverse le support 11 par un orifice 32 prévu dans le support 11 à cet effet. La position haute de l'aiguille 30 est bien visible à la figure 3. Dans cette position, la pointe 33 de l'aiguille a traversé le film 4 et a soulevé un composant 6 sous un de ses côtés uniquement. Il n'est pas obligatoire de traverser le film 4. Ce côté porte la référence 34. Le film 4 est resté maintenu en appui contre le support 11, grâce à la dépression existant dans la chambre 16. Il peut arriver que le film 4 reste légèrement soulevé autour de la pointe 33 de l'aiguille 30. En soulevant le composant 6 sur le côté 34 uniquement, le film 4 est décollé du composant 6 à partir du côté 34 et le décollement se fait progressivement jusqu'au côté 35 opposé au côté 34. Ainsi même, des composants 6, de faible épaisseur, peuvent être décollés de leur film 4 sans dommage.

La figure 1 représente également un exemple de moyens pour déplacer l'aiguille 30 verticalement selon son axe 31. L'aiguille 30 est solidaire d'un doigt 40 pouvant coulisser suivant l'axe 31 dans un corps 41 solidaire de la table 3. A son extrémité inférieure, le doigt 40 est muni d'un galet 42 pouvant se déplacer sur un coin 43. Un ressort de rappel 44 maintient le galet 42 en appui contre le coin 43. Des moyens de commande manuels ou automatiques permettent de déplacer le coin 43 selon un axe 45 perpendiculaire à l'axe 31. C'est en déplaçant le coin 43 suivant l'axe 45 que l'on obtient un déplacement de l'aiguille 30 selon son axe 31.

Avantageusement, les moyens pour soulever le composant 6 comportent plusieurs aiguilles 30 dont les axes 31 sont tous sensiblement situés dans un même plan perpendiculaire à la surface plane 10 du support 11. Plus précisément, lorsque le dispositif comporte plusieurs aiguilles 30, elles sont toutes sensiblement alignées afin de soulever le composant 6 sur un de ses côtés uniquement. Cette variante trouve une utilité particulière pour prélever des composants de forme allongée par exemple rectangulaire. Dans ce cas, on place le grand côté du rectangle au-dessus d'une ligne formée par l'intersection du plan formé par les axes 31 des différentes aiguilles 30 et de la surface plane 10.

Le dispositif comporte, de plus, des moyens de préhension du composant 6. Ces moyens sont mis en oeuvre lorsque le composant 6 est dans la position représentée à la figure 3. Ces moyens permettent, par exemple, de pincer le composant 6 soulevé, entre deux côtés 36 et 37 adjacents au côté 34. Lorsque le composant 6 est carré ou rectangulaire, les deux côtés 36 et 37 sont, figure 3, parallèles au plan de la figure. Lorsque le dispositif est utilisé pour effectuer des prélèvements unitaires de composant, on peut utiliser une pince de type brucelles pour saisir le composant 6 soulevé.

Avantageusement encore, le dispositif comporte des moyens pour positionner le film 4 par rapport aux moyens pour soulever le composant (6).

Dans un dispositif destiné au prélèvement unitaire de composant 6, ces moyens peuvent comporter des moyens de grossissement optique, dont l'axe optique est sensiblement perpendiculaire au film 4 et comprenant un réticule marquant l'emplacement des aiguilles 30 ou, plus généralement, des moyens pour soulever le composant 6. Le déplacement du film 4 se fait ici manuellement lorsque le distributeur 17 met la chambre 16 à l'échappement ou plus généralement lorsque les moyens pour maintenir le film 4 en appui contre la surface plane 10 du support 11 ne sont pas activés.

Dans un dispositif destiné au prélèvement en série importante de composants 6, les moyens pour positionner le film 4 peuvent comporter une caméra dont l'axe optique est sensiblement perpendiculaire au film 4 lorsqu'il est maintenu contre le support 11, des moyens de calcul analysant l'image de la caméra, ainsi que des moyens permettant le déplacement du film 4 par rapport aux moyens pour soulever le composant (6). Ici encore, le déplacement du film 4 se fait lorsque les moyens pour maintenir le film 4 en appui contre la surface plane 10 du support 11 ne sont pas activés.

## Revendications

1. Dispositif de prélèvement d'un ou plusieurs composant(s) (6) électronique(s) plat(s), disposés adjacents les uns par rapport aux autres, sur une première face (7) d'un film (4), **caractérisé en ce qu'**il comporte des moyens (30) pour soulever le composant du film (4), à partir de la face opposée du film (4) sur un premier côté (34) du composant (6) uniquement et assurer ainsi un décollage progressif du film à partir de ce côté jusqu'au côté opposé (35).

2. Dispositif selon la revendication 1, **caractérisé en ce qu'**il comporte des moyens pour maintenir une deuxième face (9) du film (4) en appui contre une surface plane (10) d'un support (11) et **en ce que** les moyens pour soulever le composant comportent au moins une aiguille (30) pouvant se déplacer suivant son axe (31), sensiblement perpendiculairement à la surface plane (10) du support (11) en traversant le support (11) de façon à soulever le film (4) sensiblement sous le premier côté (34) du composant (6).

3. Dispositif selon la revendication 2, **caractérisé en ce que** les moyens pour soulever le composant comportent plusieurs aiguilles (30) dont les axes (31) sont sensiblement situés dans un plan perpendiculaire à la surface plane (10) du support (11).

4. Dispositif selon l'une des revendications 2 ou 3, **caractérisé en ce que** l'aiguille (30) perce le film (4) lors de son déplacement selon son axe (31).

5. Dispositif selon l'une des revendications 2 à 4, **caractérisé en ce que** les moyens pour maintenir la deuxième face (9) du film (4) comportent au moins un orifice (13) débouchant sur la surface plane (10) du support (11) et communiquant avec des moyens générant une dépression par rapport à la pression de l'air ambiant.

6. Dispositif selon l'une des revendications précédentes, **caractérisé en ce qu'**il comporte des moyens de préhension du composant (6).

7. Dispositif selon la revendication 6, **caractérisé en ce qu'**il comporte des moyens de préhension permettant de pincer le composant (6) entre un deuxième (36) et un troisième (37) côté du composant, les deuxième et troisième côtés (36, 37) étant adjacents au premier côté (34).

8. Dispositif selon l'une des revendications précédentes, **caractérisé en ce qu'**il comporte des moyens pour positionner le film (4) par rapport aux moyens pour soulever le composant (6).

9. Dispositif selon la revendication 8, **caractérisé en ce que** les moyens pour positionner le film (4) comportent des moyens de grossissement optique comprenant un réticule marquant l'emplacement des moyens pour soulever le composant (6) et des moyens permettant le déplacement du film (4) par rapport aux moyens pour soulever le composant.

10. Dispositif selon la revendication 8, **caractérisé en ce que** les moyens pour positionner le film (4) comportent une caméra dont l'axe optique est sensiblement perpendiculaire au film (4), des moyens de calculs analysant l'image de la caméra et des moyens permettant le déplacement du film (4) par rapport aux moyens (30) pour soulever le composant (6).

## Claims

1. Device for sampling one or more flat electronic components, disposed adjacent to each other, on a first side (7) of a film (4), **characterized in that** it comprises means (30) for lifting the component from the film (4), from the opposite side of the film (4), on a first side (34) of the component (6) only and so ensuring that the film is gradually separated from this side to the opposite side (35).

2. Device according to Claim 1, **characterized in that** it comprises means for securing a second side (9) of the film (4) pressed against a flat surface (10) of a support (11), and **in that** the means for lifting the component comprise at least one needle (30) that can be moved along its axis (31), roughly perpendicularly to the flat surface (10) of the support (11), passing through the support (11) so as to lift the film (4) roughly under the first side (34) of the component (6).

3. Device according to Claim 2, **characterized in that** the means for lifting the component comprise a number of needles (30), the axes (31) of which are located roughly in a plane perpendicular to the flat surface (10) of the support (11).

4. Device according to one of Claims 2 or 3, **characterized in that** the needle (30) pierces the film (4) when moved along its axis (31).

5. Device according to one of Claims 2 to 4, **characterized in that** the means for securing the second side (9) of the film (4) include at least one orifice (13) opening out onto the flat surface (10) of the support (11) and communicating with means generating a reduced pressure relative to the ambient air pressure.

6. Device according to one of the preceding claims, **characterized in that** it includes means for gripping the component (6).

7. Device according to Claim 6, **characterized in that** it includes gripping means for clamping the component (6) between a second (36) and a third (37) side of the component, the second and third sides (36, 37) being adjacent to the first side (34).

8. Device according to one of the preceding claims, **characterized in that** it includes means for positioning the film (4) relative to the means for lifting the component (6).

9. Device according to Claim 8, **characterized in that** the means for positioning the film (4) include optical enlargement means comprising a reticule marking the location of the means for lifting the component (6) and of the means for moving the film (4) relative to the means for lifting the component.

10. Device according to Claim 8, **characterized in that** the means for positioning the film (4) include a camera, the optical axis of which is roughly perpendicular to the film (4), computation means analysing the image from the camera and means for moving the film (4) relative to the means (30) for lifting the component (6).

## Patentansprüche

1. Vorrichtung zur Entnahme eines flachen elektronischen Bauteils oder mehrerer flacher elektronischer Bauteile (6), die auf einer ersten Fläche (7) einer dünnen Folie (4) nebeneinander angeordnet sind, **dadurch gekennzeichnet, dass** sie Mittel (30) aufweist, um das Bauteil ausgehend von der gegenüberliegenden Fläche der Folie (4) nur an einer ersten Seite (34) des Bauteils (6) von der Folie (4) abzuheben und so ein progressives Ablösen von der Folie ausgehend von dieser Seite bis zur gegenüberliegenden Seite (35) zu gewährleisten.

2. Vorrichtung nach Anspruch 1, **dadurch gekennzeichnet, dass** sie Mittel aufweist, um eine zweite Fläche (9) der Folie (4) gegen eine ebene Oberfläche (10) eines Trägers (11) in Anlage zu halten, und dass die Mittel zum Anheben des Bauteils mindestens eine Nadel (30) aufweisen, die sich gemäß ihrer Achse (31) im Wesentlichen lotrecht zur ebenen Oberfläche (10) des Trägers (11) bewegen kann, indem sie den Träger (11) durchquert, um die Folie (4) im Wesentlichen unter der ersten Seite (34) des Bauteils (6) anzuheben.

3. Vorrichtung nach Anspruch 2, **dadurch gekennzeichnet, dass** die Mittel zum Anheben des Bauteils mehrere Nadeln (30) aufweisen, deren Achsen (31) im Wesentlichen in einer zur ebenen Oberfläche (10) des Trägers (11) lotrechten Ebene liegen.

4. Vorrichtung nach einem der Ansprüche 2 oder 3, **dadurch gekennzeichnet, dass** die Nadel (30) bei ihrer Bewegung entlang ihrer Achse (31) die Folie (4) durchbohrt.

5. Vorrichtung nach einem der Ansprüche 2 bis 4, **dadurch gekennzeichnet, dass** die Mittel, um die zweite Fläche (9) der Folie (4) zu halten, mindestens eine Öffnung (13) aufweisen, die an der ebenen Oberfläche (10) des Trägers (11) mündet und mit Mitteln in Verbindung steht, die bezüglich des Drucks der Umgebungsluft einen Unterdruck erzeugen.

6. Vorrichtung nach einem der vorhergehenden Ansprüche, **dadurch gekennzeichnet, dass** sie Mittel zum Ergreifen des Bauteils (6) aufweist.

7. Vorrichtung nach Anspruch 6, **dadurch gekennzeichnet, dass** sie Greifmittel aufweist, die es ermöglichen, das Bauteil (6) zwischen einer zweiten (36) und einer dritten Seite (37) des Bauteils einzuklemmen, wobei die zweite und die dritte Seite (36, 37) der ersten Seite (34) benachbart sind.

8. Vorrichtung nach einem der vorhergehenden Ansprüche, **dadurch gekennzeichnet, dass** sie Mittel aufweist, um die Folie (4) bezüglich der Mittel zum Anheben des Bauteils (6) zu positionieren.

9. Vorrichtung nach Anspruch 8, **dadurch gekennzeichnet, dass** die Mittel zum Positionieren der Folie (4) Mittel zur optischen Vergrößerung, die ein Fadenkreuz aufweisen, das die Einbaustelle der Mittel zum Anheben des Bauteils (6) markiert, und Mittel aufweisen, die das Verschieben der Folie (4) bezüglich der Mittel zum Anheben des Bauteils ermöglichen.

10. Vorrichtung nach Anspruch 8, **dadurch gekennzeichnet, dass** die Mittel zur Positionierung der Folie (4) eine Kamera, deren optische Achse im Wesentlichen lotrecht zur Folie (4) liegt, Rechenmittel, die das Bild der Kamera analysieren, und Mittel aufweisen, die das Verschieben der Folie (4) bezüglich der Mittel (30) zum Anheben des Bauteils (6) ermöglichen.
